(19) Europäisches Patentamt
European Patent Office
Office européen des brevets

(11) **EP 1 866 911 B1**

(12) **EUROPEAN PATENT SPECIFICATION**

(45) Date of publication and mention
of the grant of the patent:
**09.06.2010 Bulletin 2010/23**

(51) Int Cl.:
***G10L 19/00*** (2006.01)    ***G10L 19/14*** (2006.01)
***H04S 3/00*** (2006.01)

(21) Application number: **06711111.2**

(22) Date of filing: **16.03.2006**

(86) International application number:
**PCT/IB2006/050819**

(87) International publication number:
**WO 2006/103581 (05.10.2006 Gazette 2006/40)**

(54) **SCALABLE MULTI-CHANNEL AUDIO CODING**

SKALIERBARE MEHRKANAL-AUDIOKODIERUNG

CODAGE AUDIO MULTICANAUX POUVANT ETRE MIS A L'ECHELLE

(84) Designated Contracting States:
**AT BE BG CH CY CZ DE DK EE ES FI FR GB GR HU IE IS IT LI LT LU LV MC NL PL PT RO SE SI SK TR**

(30) Priority: **30.03.2005 EP 05102506**
         **18.04.2005 EP 05103077**

(43) Date of publication of application:
**19.12.2007 Bulletin 2007/51**

(73) Proprietor: **Koninklijke Philips Electronics N.V.
5621 BA Eindhoven (NL)**

(72) Inventors:
• **MYBURG, Francois, P.**
**NL-5656 AA Eindhoven (NL)**
• **SCHUIJERS, Erik, G., P.**
**NL-5656 AA Eindhoven (NL)**

(74) Representative: **Groenendaal, Antonius W. M.
Philips
Intellectual Property & Standards
P.O. Box 220
5600 AE Eindhoven (NL)**

(56) References cited:
**EP-A- 0 918 407**      **EP-A- 1 376 538**
**WO-A-2004/008805**

**Description**

The invention relates to the field of high quality audio coding. Especially, the invention relates to the field of high quality coding of multi-channel audio data. More specifically, the invention defines encoders and decoders and methods for encoding and decoding multi-channel audio data.

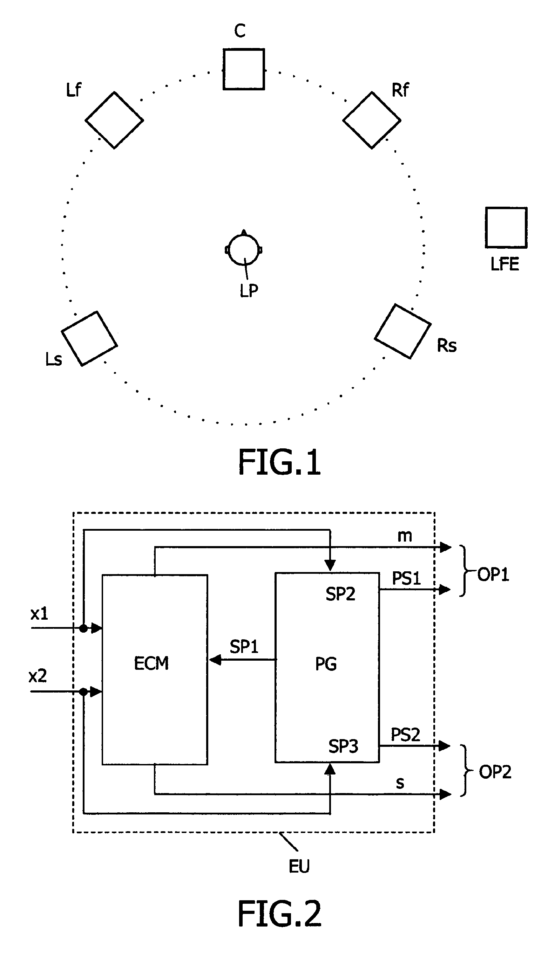

Although many multi-channel configurations/set-ups are possible, the 5.1 configuration/set-up is the most popular (see also Fig. 1). The typical multi-channel 5.1 setup consists of five speakers, namely left front (Lf), right front (Rf), centre (C), left surround (Ls), and right surround (Rs) speakers complemented by an additional LFE (low frequency enhancement) speaker to be placed at an arbitrary angle. In the past several approaches for compressing multi-channel audio data, such as the 5.1 multi-channel audio data have been considered. A brief overview is given below.

In the MPEG-2 Audio standard, ISO/IEC 13818-3:1998 Information technology -- Generic coding of moving pictures and associated audio information -- Part 3: Audio, a provision is made for coding multi-channel audio while maintaining backward compatibility towards MPEG-1 Audio, ISO/IEC 11172-3:1993 Information technologyCoding of moving pictures and associated audio for digital storage media at up to about 1,5 Mbit/s -- Part 3: Audio, which caters only for the coding of mono and stereo audio. Backward compatibility is achieved by forming a basic stereo signal, derived from the multi-channel content, which is placed in the Data part of the MPEG-1 bit stream. Three additional signals are then placed in the Ancillary Data part of the MPEG-1 bit stream. This technique is referred to as matrixing. An MPEG-1 Audio decoder can generate a meaningful stereo signal (Lo, Ro) from the bit stream, while an MPEG-2 Audio decoder can extract the additional channels and reconstruct a decoded version of the 5 input channels. Backward compatibility comes at the cost of a high bit rate. Typically, a bit rate of 640 kbit/s is required to obtain a high audio quality for five channel material with MPEG-2 Layer II.

In MPEG-2 Advanced Audio Coding (AAC), ISO/IEC TR 13818-5:1997/Amd 1:1999 Advanced Audio Coding (AAC), multi-channel audio is coded in a non-backward compatible format. This allows the coder more freedom and has the advantage that a higher audio quality (transparent) can be achieved at a bit rate of 320 kbit/s, compared to MPEG-2 Layer II at 640 kbit/s. In a 5(.1) channel configuration, AAC may code the channel pairs that are symmetric to the listener by means of employing the Mid-Side (MS) stereo tool: (Lf, Rf) and (Ls, Rs). The centre (C) and (optional) LFE channels are coded separately. Alternatively, Intensity Stereo (IS) coding can be employed to combine several audio channels into one channel, and additionally providing scaling information for each channel.

In parametric multi-channel audio coding, perceptually relevant cues (or spatial parameters), such as inter-channel intensity differences (IID), inter-channel time differences (ITD) and inter-channel coherence (ICC), are measured between channels in a multi-channel signal. A more thorough description of spatial parameters may be found in Christof Faller: "Coding of Spatial Audio Compatible with Different Playback Formats", AES Convention Paper, AES 117th Convention, San Francisco, USA, 2004 October 28-31. Furthermore, the multi-channel representation is down-mixed to a stereo or mono signal that can be encoded with a standard mono or stereo encoder. An important requirement is that the stereo or mono down-mix should be of a sufficient audio quality, e.g. at least comparable to the ITU-R Recommendation BS.775-1 down-mix. The transmitted information thus comprises a coded version of the mono or stereo signal and the spatial parameters. The mono or stereo down-mix is coded at a bit rate substantially lower than that required for coding the original multi-channel audio signal, and the spatial parameters require a very small transmission bandwidth. Therefore, the down-mix and spatial parameters can be coded at a total bit rate that is only a fraction of the bit rate required when all channels are coded. The parametric decoder generates a high-quality approximation of the original multi-channel audio signal from the transmitted mono or stereo down-mix and spatial parameters.

A scalable stereo audio encoding/decoding approach is described in published European patent application EP 0918407 A2.

It may be seen as an object of the present invention to provide a scalable multi-channel audio signal encoder that provides a high efficiency, provides a high signal quality and at the same time provides an encoded signal that is back-ward compatible.

According to a first aspect, the invention provides an audio encoder adapted to encode a multi-channel audio signal, the encoder comprising:

- an encoder combination module for generating a dominant signal part and a residual signal part being a combined representation of first and second audio signals, the dominant and residual signal parts being obtained by applying a mathematical procedure to the first and second audio signals, wherein the mathematical procedure involves a first spatial parameter comprising a description of spatial properties of the first and second audio signals,
- a parameter generator for generating
- a first parameter set comprising a second spatial parameter, and
- a second parameter set comprising a third spatial parameter, and
- an output generator for generating an encoded output signal comprising
- a first output part comprising the dominant signal part and the first parameter set, and

- a second output part comprising the residual signal part and the second parameter set.

In the encoder combination module, first and second audio signals are combined into dominant and residual signal parts. By "dominant and residual signal parts" are understood two audio signals where the dominant signal contains the dominant or major parts of the first and second audio signals, while the residual signal contains a residual or less significant part of the first and second audio signals. By "spatial parameter" is understood a parameter that can be mathematically expressed and based on or derived from one or more spatial properties of a signal pair. A non-exhaustive list of such spatial properties that can be calculated are: inter-channel intensity differences (IID), inter-channel time differences (ITD) and inter-channel coherence (ICC). The encoder combination module preferably generates the dominant and residual signal parts such that these signal parts are less correlated than the first and second audio signals. Preferably, the dominant and residual signal parts are generated so that they are not correlated, i.e. orthogonal, or at least they should be as least correlated as possible.

The residual signal part may be low pass filtered before being converted into an output bit stream, in order to be represented in a bit stream thus requiring only a very limited amount of bit rate. A cut off frequency for such low pass filtering may be in the interval 500 Hz to 10 kHz, e.g. 2 kHz.

The encoder combination module may be adapted to combine first, second and third audio signals to first and second dominant signal parts instead of combining two audio signals into one dominant signal, such as described above.

The encoder according to the first aspect provides a scalable encoded representation of the first and second audio signals. Using the first output part, or base layer part, it is possible to decode the first and second audio signals with an acceptable resulting sound quality by using existing decoders. However, by using a decoder capable of utilizing the second output part, or refinement layer part, it is possible to obtain a higher signal quality. Thus, to use the second output part in a decoder can be seen as optional and is only necessary in case the best possible sound quality is desired.

In a preferred embodiment, the residual signal part comprises a difference between the first and second audio signals. The residual signal part may be defined precisely as a difference between the first and second audio signals.

In preferred embodiments, the mathematical procedure comprises a rotation in a two-dimensional signal space.

The third spatial parameter may comprise a difference between the second spatial parameter and the first spatial parameter. The third spatial parameter may involve differential coding.

The second spatial parameter may comprise a coherence based ICC parameter. The third spatial parameter may comprise a difference between a coherence based ICC parameter and a correlation based ICC parameter. In a preferred embodiment, the second spatial parameter comprises a coherence based ICC parameter, while the third spatial parameter comprises a difference between the second spatial parameter and a correlation based ICC parameter.

The encoder may further be adapted to encode a third, a fourth, a fifth and a sixth or even more audio signals according to the principles of the first aspect by combining these audio signals together with the first and second audio signals and generate the first and second output parts in response thereto. Preferably, such encoder is adapted to encode a 5.1 audio signal by using a configuration comprising a plurality of the encoder combination modules. In principle, the encoder principle according to the first aspect can be used to encode any multi-channel format audio data.

In a second aspect, the invention provides an audio decoder for generating a multi-channel audio signal based on an encoded signal, the decoder comprising:

- a decoder combination module for generating first and second audio signals based on a dominant signal part, a residual signal part and first and second spatial parameter sets, the spatial parameters comprising a description of spatial properties of the first and second audio signals, wherein the residual signal part and the second spatial parameters are involved in determining a mixing matrix that is used to generate the first and second audio signals. As described in connection with the first aspect, existing decoders can be used to decode the encoded output signal from an encoder according to the invention by only utilizing the dominant signal part and first spatial parameters. However, the decoder according to the second aspect will be able to utilize the second encoded output part, i.e. the residual signal part and a spatial parameter, to determine a mixing matrix that is identically inverse to the encoder combination involved in the encoding process, and thus a perfect regeneration of the first and second audio signals can be obtained.

In preferred embodiments, the decoder comprises a de-correlator for receiving the dominant signal part and generate a de-correlated dominant signal part in response thereto. Preferably, an addition of the residual signal part and the de-correlated dominant signal part is involved in determining the mixing matrix. The decoder may comprise an attenuator for attenuating the de-correlated dominant signal part prior to adding it to the residual signal part.

In preferred embodiments, the mixing matrix applies a rotation in a two-dimensional signal space to the dominant and residual signal parts.

The decoder may be adapted to receive a plurality of sets of first and second sets of parameters and a plurality of residual signal parts so as to generate a plurality of sets of first and second audio signals in response thereto. In a preferred embodiment, the decoder is adapted to receive three sets of first and second sets of parameters and three residual signal parts so as to generate three sets of first and second audio signals in response thereto, in this embodiment, the decoder can generate six independent audio channels, such as according to the 5.1 format or other multi-channel format.

In preferred embodiments the decoder comprises a plurality of one-to-two channel mixing-matrices arranged in a suitable configuration so as to enable the decoder to decode an encoded signal representing more than two audio signals. For example the decoder may comprise a configuration of five mixing-matrices arranged to generate six audio signals and thus decode e.g. an encoded 5.1 audio signal.

In a third aspect, the invention provides a method of encoding a multi-channel audio signal comprising the steps of

> 1) generating a dominant signal part and a residual signal part being a combined representation of first and second audio signals, the dominant and residual signal parts being obtained by applying a mathematical procedure to the first and second audio signals, wherein the mathematical procedure involves a first spatial parameter comprising a description of spatial properties of the first and second audio signals,
> 2) generating a first parameter set comprising a second spatial parameter,
> 3) generating a second parameter set comprising a third spatial parameter, and
> 4) generating an encoded output signal comprising a first output part comprising the dominant signal part and the first parameter set, and a second output part comprising the residual signal part and the second parameter set.

The same advantages and comments as described in connection with the first aspect applies to the third aspect.

In a fourth aspect, the invention provides a method of generating a multi-channel audio signal based on an encoded signal, the method comprising the steps of:

> 1) receiving the encoded signal comprising a dominant signal part, a residual signal part, and first and second spatial parameter sets comprising a description of spatial properties of first and second audio signals,
> 2) determining a mixing matrix based on the residual signal part and the second spatial parameter set,
> 3) generating the first and second audio signals based on the determined mixing matrix.

The method may comprise the step of de-correlating the dominant signal part and generating a de-correlated dominant signal part in response thereto. The method may further comprise the step of adding the residual signal part and the de-correlated dominant signal part. The determining of the mixing matrix may be based on the added residual signal part and the de-correlated dominant signal part.

Preferably, the method comprises receiving a plurality of sets of first and second sets of parameters and a plurality of residual signal parts so as to generate a plurality of sets of first and second audio signals in response thereto. In a preferred embodiment, the method comprises receiving three sets of first and second sets of parameters and three residual signal parts so as to generate three sets of first and second audio signals in response thereto. In this embodiment, the method is capable of generating six independent audio channels such as in a 5.1 multi-channel format or equivalent.

The same advantages and comments as described for the second aspect apply for the fourth aspect.

In a fifth aspect, the invention provides an encoded multi-channel audio signal comprising

- a first signal part comprising a dominant signal part and a first parameter set comprising a description of spatial properties of first and second audio signals, and
- a second signal part comprising a residual signal part and a second parameter set comprising a description of spatial properties of the first and second audio signals.

The audio signal according to the fifth aspect provides the same advantages as set forth in connection with the first aspect, since this signal is identical with an encoded output signal from the encoder according to the first aspect.

In a sixth aspect, the invention provides a storage medium having stored thereon a signal as in the fifth aspect. The storage medium may be a hard disk, a floppy disk, a CD, a DVD, an SD card, a memory stick, a memory chip etc.

In a seventh aspect, the invention provides a computer executable program code adapted to perform the method according to the third aspect when run on a computer.

In an eighth aspect, the invention provides a computer readable storage medium comprising a computer executable program code according to the seventh aspect. The storage medium may be a hard disk, a floppy disk, a CD, a DVD, an SD card, a memory stick, a memory chip etc.

In a ninth aspect, the invention provides a computer executable program code adapted to perform the method according to the fourth aspect when run on a computer.

In a tenth aspect, the invention provides a computer readable storage medium comprising a computer executable program code according to the ninth aspect. The storage medium may be a hard disk, a floppy disk, a CD, a DVD, an SD card, a memory stick, a memory chip etc.

In an eleventh aspect, the invention provides a device comprising an encoder according to the first aspect. The device may be such as home entertainment audio equipment such as surround sound amplifiers, surround sound receivers, DVD players/recorders etc. In principle the device may be any audio device capable of handling multi-channel audio data, e.g. 5.1 format.

In a twelfth aspect, the invention provides a device comprising a decoder according to the second aspect. The device may be such as home entertainment audio equipment such as surround sound amplifiers, surround sound receivers, AN receivers, set-top boxes, DVD players/recorders etc.

The signal according to the fifth aspect is suitable for transmission through a transmission chain. Such transmission chain may comprise a server storing the signals, a network for distribution of the signals, and clients receiving the signals. The client side may comprise hardware such as e.g. computers, A/V receivers, set-top boxes, etc. Thus, the signal according to the fifth aspect is suitable for transmission of Digital Video Broadcasting, Digital Audio Broadcasting or Internet radio etc.

It is appreciated that in all of the above aspects, the first and second audio signals may be full bandwidth signals. Optionally, the first and second audio signals represent sub-band representations of respective full bandwidth audio signals. In other words, the signal processing according to the invention may be applied on full bandwidth signals or applied on a sub-band basis.

In the following the invention is described in more details with reference to the accompanying figures, of which

Fig. 1 shows a sketch of a 5.1 multi channel loudspeaker setup,
Fig. 2 shows an encoder combination unit according to the invention,
Fig. 3 shows a preferred encoder for encoding a 5.1 audio signal based on an encoder combination to a mono signal,
Fig. 4 shows a preferred decoder corresponding to the encoder of Fig. 3,
Fig. 5 shows a preferred encoder for encoding a 5.1 audio signal based on an encoder combination to a stereo signal,
Fig. 6 shows a preferred decoder corresponding to the encoder of Fig. 5, and
Fig. 7 shows a graph illustrating results of a listening test performed with the encoding principle according to the invention.

While the invention is susceptible to various modifications and alternative forms, specific embodiments have been shown by way of example in the drawings and will be described in detail herein. It should be understood, however, that the invention is not intended to be limited to the particular forms disclosed. Rather, the invention is to cover all modifications, equivalents, and alternatives falling within the scope of the invention as defined by the appended claims.

Fig. 1 shows a sketch of a typical 5.1 multi-channel audio setup with a listening person LP positioned in the centre of five loudspeakers C, Lf, Ls, Rf and Rs that receive independent audio signals. These are provided to yield the listening person LP a spatial audio impression. The 5.1 setup in addition provides a separate subwoofer LFE signal. Thus, a full signal representation for such a multi-channel setup requires altogether six independent audio channels, and thus a large bit rate is necessary to represent an audio signal for such a system at full audio quality. In the following, embodiments of the invention will be described that are capable of providing a high audio quality in a 5.1 system at a low bit rate.

Fig. 2 shows a 2-1 encoder combination unit EU according to the invention. First and second audio signals x1 x2 are input to an encoder combination module ECM where a mathematical procedure is performed on the first and second audio signals x1 x2, preferably comprising a signal rotation, in order to combine the first and second audio signals x1 x2 and generate a parametric representation thereof comprising a dominant signal part m and a residual signal part s. A first spatial parameter SP1, i.e. a parameter describing spatial signal properties of the first and second audio signals x1 x2, is involved in the mathematical encoder combination procedure.

A parameter generator PG generates first and second parameter sets PS1, PS2 based on the first and second audio signals x1, x2. The first parameter set PS1 comprises a second spatial parameter SP2, and the second parameter set PS2 comprises a third spatial parameter SP3. The encoded output signal comprises a first output part OP1 comprising the dominant signal part m and the first parameter set PS1, while a second output part OP2 comprises the residual signal part s and the second parameter set PS2.

By proper choice of the second and third spatial parameters SP2, SP3 in relation to the first spatial parameter SP1 it is possible to perform an inverse of the encoder combination or rotation procedure at the decoder side, and thus the first and second audio signals x1 x2 can be transparently decoded.

Preferably, the encoder puts the first output part in a base layer of its output bit stream, while the second output part is put into a refinement layer of the output bit stream. During decoding it is possible to use only the base layer, if a reduced signal quality is acceptable, while the best possible signal quality can be obtained if also the refinement layer is included in the decoding process.

The encoding principle described provides a scalable hybrid multi-channel audio encoder with full backwards compatibility. The decoder can be used for the following scenarios: 1) Decoded mono or stereo signal only, 2) Decoded multi-channel output without the use of residual signals, and 3) Decoded multi-channel output with residual signals.

In the following preferred embodiments of encoder combination modules and spatial parameters are described. A preferred encoder combination module combines first and second audio signals x1 x2 to a dominant signal part m and residual signal part s by maximizing the amplitude of the sum of the rotated signals according to:

$$\begin{pmatrix} m[k] \\ s[k] \end{pmatrix} = \begin{pmatrix} sc_{corr} & sc_{corr} \\ \dfrac{1}{2} & -\dfrac{1}{2} \end{pmatrix} \begin{pmatrix} x_1[k] \\ x_2[k] \end{pmatrix}, \text{where}$$

$$sc_{corr} = \min \left\{ sc_{corr,max}, \frac{1}{c_l \cos(\chi + \beta) + c_r \cos(-\chi + \beta)} \right\}.$$

(Eq 1)

The amplitude rotation coefficients involved in $sc_{corr}$ are derived from ICC and IID, i.e. they are based on spatial properties of the first and second audio signals x1 x2. These amplitude rotation coefficients are preferably calculated according to:

$$\chi = \frac{1}{2} \cos^{-1}(ICC), \beta = \tan^{-1}\left( \tan(\chi) \frac{c_r - c_l}{c_r + c_l} \right), c_l = \sqrt{\frac{IID}{1 + IID}}, c_r = \sqrt{\frac{1}{1 + IID}}.$$

The residual signal s is selected to be the difference between x1 and x2. Note that this matrix is always invertible, as $sc_{corr}$ can never be zero, which means that a perfect reconstruction can be achieved as long as $sc_{corr}$ is known. A suitable value for the clipping constant $sc_{corr,max}$ is 1.2.

To derive $sc_{corr}$ in the decoder, the second parameter set PS2 preferably comprises a difference between coherence and correlation parameters and thus transmitted together with the corresponding residual signal s in a refinement layer in the scalable bit stream The first parameter set PS1 is selected to comprise either coherence parameters or correlation parameters and thus to be transmitted in the base layer together with the dominant signal part m

When the residual signal s is available to the decoder, correlation parameters are derived, which facilitates the calculation of $sc_{corr}$ and an inverse of the mixing matrix of Eq 1 can be determined:

$$\begin{pmatrix} x_1[k] \\ x_2[k] \end{pmatrix} = \begin{pmatrix} \dfrac{1}{2sc_{corr}} & 1 \\ \dfrac{1}{2sc_{corr}} & -1 \end{pmatrix} \begin{pmatrix} m[k] \\ s[k] \end{pmatrix}.$$

In another preferred embodiment, the encoder combination module is Principal Component Analysis (PCA) based and mixes the first and second audio signals x1, x2 according to:

$$\begin{pmatrix} m[k] \\ s[k] \end{pmatrix} = \begin{pmatrix} \cos(\alpha) & \sin(\alpha) \\ -\sin(\alpha) & \cos(\alpha) \end{pmatrix} \begin{pmatrix} x_1[k] \\ x_2[k] \end{pmatrix},$$

where a preferred coefficient a is based on ICC and IID according to:

$$\alpha = \frac{1}{2} \tan^{-1} \left( \frac{2ICC \cdot c}{c^2 - 1} \right), c = 10^{\frac{IID}{20}}.$$

Preferred options for encoding of the second parameter set PS2 to be included in the refinement layer are correlation parameters that include the following:

1) Time- or frequency differential coding of the correlation parameters, independent of the coherence parameters in the base layer.
2) Differential coding of the correlation parameters with regard to the coherence parameters in the base layer (i.e. $\Delta ICC = ICC_{correlation}-ICC_{coherence}$). A combination of 1 and 2, depending on which requires the least amount of bits.

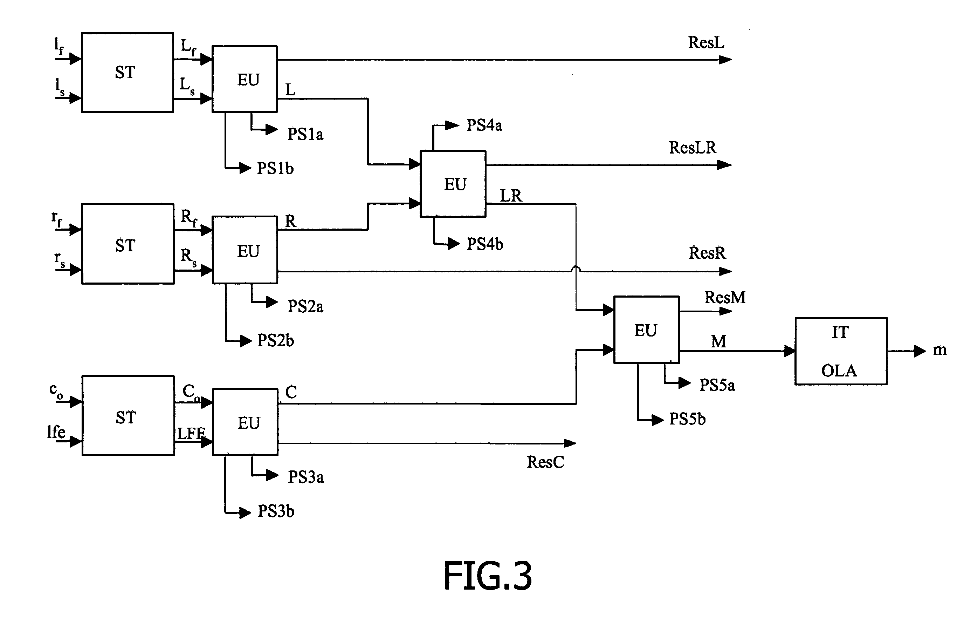

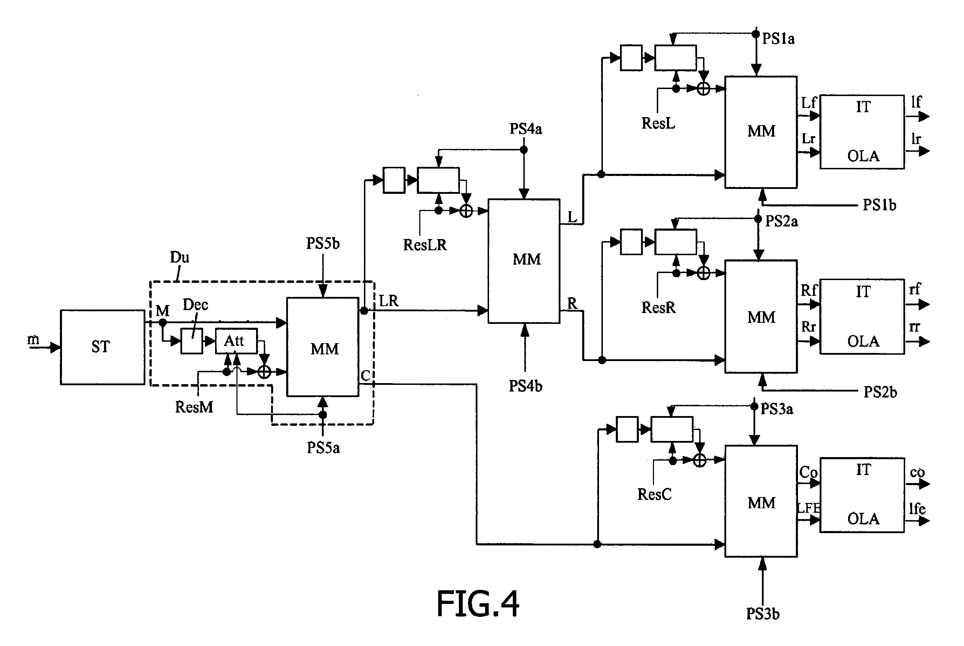

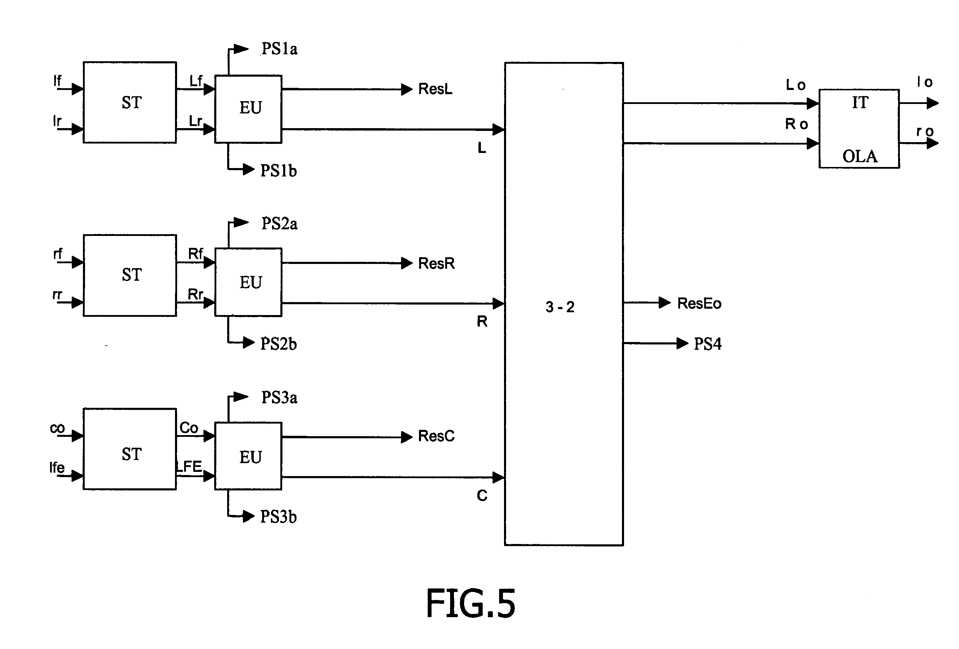

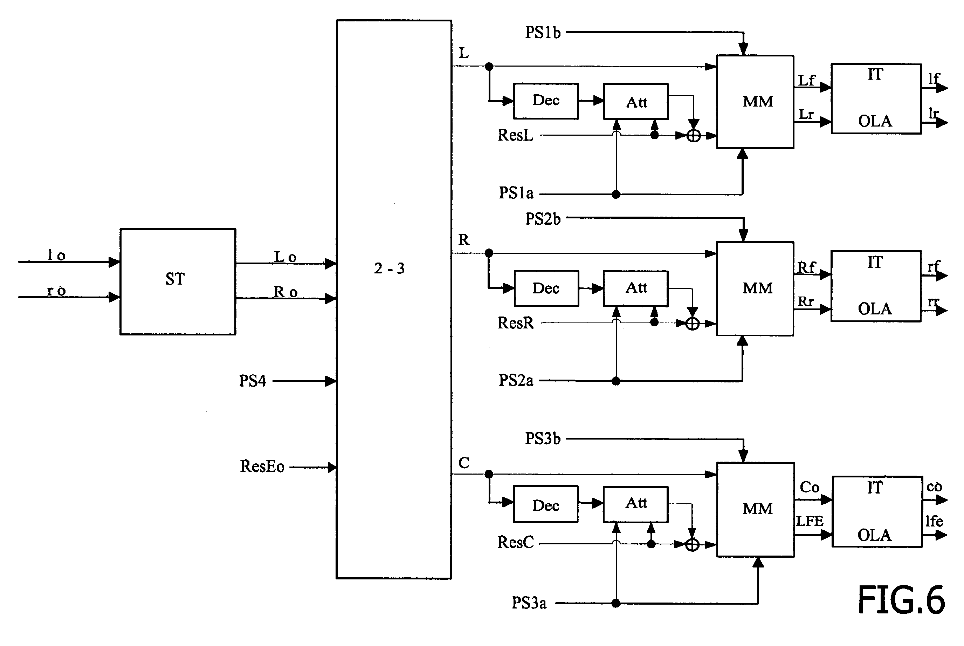

3) Figs. 3 and 4 illustrate preferred configurations of a 5.1 format encoder and a corresponding 5.1 decoder, respectively, that are based on an encoder combination to an encoded mono signal. Figs. 5 and 6 illustrate an alternative 5.1 format encoder and a corresponding decoder, respectively, that are based on an encoder combination to an encoded stereo signal.

Fig. 3 shows an encoder configuration based on a combination of six independent audio signals lf, ls, rf, rs, co, lfe to a mono signal m, e.g. the six audio signals represent signals lf, ls, rf, rs, co, lfe in a 5.1 format. The encoder comprises five encoder combination units EU, such as described in the foregoing, these units EU being arranged to successively combine the six signals lf, ls, rf, rs, co, lfe into a single mono signal m. An initial segmentation and transformation step ST is performed for signal pairs prior to encoder combination. This step ST comprises segmenting the time-domain audio signals into overlapping segments and then transforming these overlapping time-domain segments into frequency domain representations (indicated by capital letters).
After the segmentation and transformation ST, the two left channels Lf and Ls are combined to a dominant signal part L, first and second parameter sets PS1a, PS1b and a residual signal ResL. The two right channels Rf, Rs are combined to a dominant signal part R, first and second parameter sets PS2a, PS2b and a residual signal ResR. The resulting dominant signal parts L and R are then combined to a dominant signal part LR, a residual signal part ResLR and first and second parameters PS4a, PS4b. The centre channel C0 and the sub-woofer channel LFE are combined to a dominant signal part C, first and second parameter sets PS3a, PS3b and a residual signal ResC. Finally, the dominant signal parts C and LR are combined to a dominant signal part M, residual signal part ResM and first and second parameters PS5a, PS5b.
Preferably, the first and second sets of parameters PS1a-PS5a, PS1b-PS5b are determined independently for a number of frequency bands (sub-bands) in a segment before quantization, coding and transmission, however if preferred, the processing may be performed on full bandwidth signals. After signal analysis and processing is applied, an optional processing may be applied IT, OLA: segments may be inverse transformed IT back into the time domain, and segments may be overlapped and added OLA to obtain the time-domain mono audio signal m. Altogether the encoder generates a first output part comprising the dominant signal part m and five parameter sets PS1a-PS5a, and a second output part comprising five residual signal parts ResL, ResR, ResLR, ResM, ResC, and five parameter sets PS1b, PS5b.
Fig. 4 shows a decoder corresponding to the encoder of Fig. 3, i.e. it is adapted to receive the output signal from the encoder of Fig. 3. The decoder essentially applies the inverse of the processing described for Fig. 3. The decoder comprises an (optional) initial segmentation and frequency transformation ST is applied to the dominant signal part m. The decoder comprises five similar decoder combination units DU, of which one is indicated with a dashed line. The decoder combination unit DU comprises a mixing-matrix MM that generates first and second signals based on a dominant signal part. The mixing-matrix MM, i.e. the inverse of the mixing matrix applied in the encoder combination module ECM, is determined based on received dominant signal part, residual part and first and second parameter sets.
In the first decoder combination unit DU indicated in Fig. 4, the dominant signal M is first de-correlated in a de-correlator Dec and then attenuated in an attenuator Att. The de-correlated and attenuated dominant signal part is then added to the residual signal part ResM. This added signal is then used to determine the mixing-matrix MM. The attenuator Att is set in response to the residual signal part ResM and the first parameter set PS5a. Finally, the mixing-matrix MM is determined using the first and second parameter sets PS5a, PS5b. The determined mixing-matrix MM then combines the dominant signal part M to a first output signal LR and a second output signal C. These first and second output signals LR, C are then applied to respective encoder combination units and successively combined to yield L, R, and C0, LFE, respectively. Finally, L is decoder combined to yield Lf and Lr, while R is decoder combined to yield Rf and Rr. After signal analysis and processing is applied, segments are inverse transformed IT back into the time domain, and segments are overlapped and added OLA to obtain the time-domain representations lf; lr, rf, rr, co, lfe. This inverse transformation and overlap-add IT, OLA are optional.

Fig. 5 show an encoder embodiment where three encoder combination units, each functioning according to the principles described in connection with the encoder of Fig. 3, are used to combine six audio signals Lf, Lr, Rf, Rr, C0, LFE in pairs to three dominant signal parts L, R, C with associated first parameter sets PS1a-PS3a, second parameter sets PS1b-PS3b and residual signal parts ResL, ResR, ResC. A 3-2 encoder combination unit is then applied to the three dominant signal part L, R and C resulting in two dominant signal parts L0, R0 and residual signal part ResEo and a parameter set PS4. Optionally, an initial segmentation and frequency domain transformation ST is applied, and a final inverse transformation IT and overlap-add OLA is (optionally) applied, such as also described in connection with Fig. 3.

Fig. 6 shows a decoder configuration adapted to decode an output from the encoder of Fig. 5. After an (optional) initial segmentation and frequency domain transformation ST of input signals lo, ro, a 2-3 decoder combination module generates dominant signal parts L, R, C in response to dominant signal parts Lo, Ro, residual signal part ResEo together with parameter set PS4. These three dominant signal parts L, R, C are then processed in respective decoder combination units similar to the decoder combination units DU described in connection with the decoder of Fig. 4. A final inverse transformation IT and overlap-add OLA is (optionally) applied as also described above.

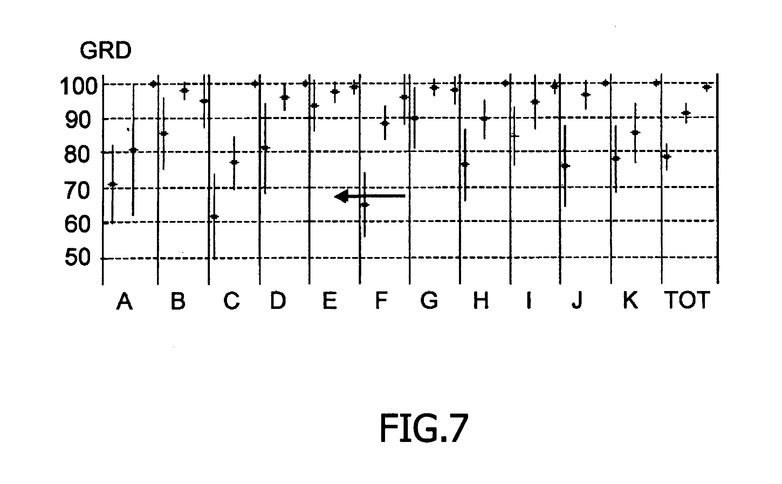

Fig. 7 illustrates results of a listening test performed for five trained listeners. The musical items A-K used are those specified in the MPEG "Spatial Audio Coding" work item For each item A-K, results for three encoded versions were included in the test: 1) Decoder without residuals - shown to the left, 2) Spatial encoder with residuals, i.e. a decoder according to the invention - shown in the middle, and 3) Reference (hidden) - shown to the right,- shown to the right. A total average of the items A-K is shown as TOT. For each encoded version an average grade GRD is indicated with an asterisk (*), while +/standard deviation for answers within listeners are indicated therefrom.

For scenario 2) and 3) the encoder/decoder principle illustrated in Figs. 5 and 6 was used. In scenario 2) residual signal parts were discarded. For scenario 3), three residual signal parts band limited to 2 kHz, were used: Residual signal part for left channel ResL, residual signal part for right channel ResR, and residual signal part ResEo for the decoder combination module 3-2. Each one of the residual signals ResL, ResR, ResEo was coded at a bit rate of 8 kbit/s, and the extra spatial parameters (being differences between correlation (refinement layer) and coherence parameters (base layer)) required an estimated bit rate of 700 bit/s. Hence, the total extra residual-related bit rate is then approximately 25 kbit/s. The standard spatial parameters (to be placed in the base layer), required an estimated 10 kbit/s. The total spatial data rate is thus approximately 35 kbit/s. No core codec was applied to the stereo signal lo, ro.

From the results, it is clear that a large quality improvement can be obtained by utilizing three residual signals coded at a low bit rate. Furthermore, the total average quality grade is +/- 92, very close to what is considered "transparent" audio quality.

The encoder and decoder according to the invention may be applied within all applications involving multi-channel audio coding, including: Digital Video Broadcasting (DVB), Digital Audio Broadcasting (DAB), Internet radio, Electronic Music Distribution.

Reference signs in the claims merely serve to increase readability. These reference signs should not in anyway be construed as limiting the scope of the claims, but are only included illustrating examples only.

**Claims**

1. Audio encoder adapted to encode a multi-channel audio signal, the encoder comprising:

- an encoder combination module (ECM) for generating a dominant signal part (m) and a residual signal part (s) being a combined representation of first and second audio signals (x1, x2), the dominant and residual signal parts (m, s) being obtained by applying a mathematical procedure to the first and second audio signals (x1, x2), wherein the mathematical procedure involves a first spatial parameter (SP1) comprising a description of spatial properties of the first and second audio signals (x1, x2),
- a parameter generator (PG) for generating

- a first parameter set (PS1) comprising a second spatial parameter (SP2), and
- a second parameter set (PS2) comprising a third spatial parameter (SP3), and
**characterized by** the encoder comprising;
- an output generator for generating an encoded output signal comprising
- a first output part (OP1) comprising the dominant signal part (m) and the first parameter set (PS1), and
- a second output part (OP2) comprising the residual signal part (s) and the second parameter set (PS2).

2.   Audio encoder according to claim 1, wherein the third spatial parameter (SP3) comprises a difference between the second spatial parameter (SP2) and the first spatial parameter (SP1).

3.   Audio encoder according to claim 1, wherein the second spatial parameter (SP2) comprises a coherence based parameter.

4.   Audio encoder according to claim 1, wherein the third spatial parameter (SP3) comprises a difference between a coherence based parameter and a correlation based parameter.

5.   Audio encoder according to claim 1, wherein the residual signal part (s) comprises a difference between the first and second audio signals (x1, x2).

6.   Audio encoder according to claim 1, wherein the encoder combination module (ECM) generate is adapted to the dominant and residual signal parts (m, s) such that these signal parts (m, s) are less correlated than the first and second audio signals (x1, x2).

7.   Audio encoder according to claim 1, further being adapted to receive third, fourth, fifth and sixth audio signals and down-mix these signals together with the first and second audio signals (x1, x2) and to generate the first and second output parts in response thereto.

8.   Audio decoder for generating a multi-channel audio signal based on an encoded signal, the decoder comprising:

- a decoder combination unit (DU) for generating first and second audio signals based on a dominant signal part, a residual signal part and first and second sets of parameters, the first and second sets of parameters comprising a description of spatial properties of the first and second audio signals, wherein the residual signal part and the second set of parameters are involved in determining a mixing matrix (MM) that is used to generate the first and second audio signals.

9.   Audio decoder according to claim 8, wherein the decoder comprises a de-correlator (Dec) for receiving the dominant signal part and generate a de-correlated dominant signal part in response thereto.

10.   Audio decoder according to claim 9, wherein an addition of the residual signal part and the de-correlated dominant signal part is involved in determining the mixing matrix (MM).

11.   Audio decoder according to claim 10, wherein the decoder comprises an attenuator (Att) for attenuating the de-correlated dominant signal part prior to adding it to the residual signal part.

12.   Audio decoder according to claim 8, adapted to receive a plurality of sets of first and second sets of parameters and a plurality of residual signal parts so as to generate a plurality of sets of first and second audio signals in response thereto.

13.   Audio decoder according to claim 12, wherein the decoder is adapted to receive three sets of first and second sets of parameters and three residual signal parts so as to generate three sets of first and second audio signals in response thereto.

14.   A method of encoding a multi-channel audio signal comprising the steps of:

1) generating a dominant signal part (m) and a residual signal part (s) being a combined representation of first and second audio signals (x1, x2), the dominant and residual signal parts (m, s) being obtained by applying a mathematical procedure to the first and second audio signals (x1, x2), wherein the mathematical procedure involves a first spatial parameter comprising a description of spatial properties of the first and second audio

9

signals (x1, x2),

2) generating a first parameter set comprising a second spatial parameter,

3) generating a second parameter set comprising a third spatial parameter, and

**characterised by**

4) generating an encoded output signal comprising a first output part comprising the dominant signal part (m) and the first parameter set, and a second output part comprising the residual signal part (s) and the second parameter set.

15. A method of generating a multi-channel audio signal based on an encoded signal, the method comprising the steps of:

1) receiving the encoded signal comprising a dominant signal part, a residual signal part, and first and second parameter sets comprising a description of spatial properties of first and second audio signals,

2) determining a mixing matrix (MM) based on the residual signal part and the second parameter set,

3) generating the first and second audio signals based on the determined mixing matrix.

16. A method according to claim 15, comprising the step of de-correlating the dominant signal part and generating a de-correlated dominant signal part in response thereto.

17. A method according to claim 16, further comprising the step of adding the residual signal part and the de-correlated dominant signal part.

18. A method according to claim 17, wherein the determining of the mixing matrix (MM) is based on the added residual signal part and the de-correlated dominant signal part.

19. A method according to claim 15, comprising receiving a plurality of sets of first and second sets of parameters and a plurality of residual signal parts so as to generate a plurality of sets of first and second audio signals in response thereto.

20. A method according to claim 19, comprising receiving three sets of first and second sets of parameters and three residual signal parts so as to generate three sets of first and second audio signals in response thereto.

21. An encoded multi-channel audio signal comprising:

- a first signal part (OP1) comprising a dominant signal part (m) and a first parameter set (PS1) comprising a description of spatial properties of first and second audio signals (x1, x2), and

- a second signal part (OP2) comprising a residual signal part (s) and a second parameter set (PS2) comprising a description of spatial properties of the first and second audio signals (x1, x2).

22. A storage medium having stored thereon a signal as in claim 21.

23. Computer executable program code adapted to perform the method according to claim 14 when run on a computer.

24. Computer readable storage medium comprising a computer executable program code according to claim 23.

25. Computer executable program code adapted to perform the method according to claim 15 when run on a computer.

26. Computer readable storage medium comprising a computer executable program code according to claim 25.

27. Device comprising an encoder according to claim 1.

28. Device comprising a decoder according to claim 8.

**Patentansprüche**

1. Audio-Kodierer, vorgesehen zum Kodieren eines Mehrkanal-Audiosignals, wobei der Kodierer Folgendes umfasst:

- ein Kodiererkombinationsmodul (ECM = "encoder combination module") zum Erzeugen eines dominanten Signalteils (m) und eines Restsignalteils (s), wobei es sich um eine kombinierte Darstellung eines ersten und eines zweiten Audiosignals (x1, x2) handelt, wobei der dominante und der Restsignalteil (m, s) durch Anwendung einer mathematischen Prozedur an dem ersten und zweiten Audiosignal (x1, x2) erhalten werden, wobei die mathematische Prozedur erfordert, dass ein erster räumlicher Parameter (SP1) eine Beschreibung räumlicher Eigenschaften des ersten und des zweiten Audiosignals (x1, x2) enthält,
- einen Parametergenerator (PG) zum Erzeugen eines ersten Parametersatzes (PS1), der einen zweiten räumlichen Parameter (SP2) enthält, und eines zweiten Parametersatzes (PS2), der einen dritten räumlichen Parameter (SP3) enthält,

**dadurch gekennzeichnet, dass** der Kodierer Folgendes umfasst:

- einen Ausgangsgenerator zum Erzeugen eines kodierten Ausgangssignals mit einem ersten Ausgangteil (OP1) mit dem dominanten Signalteil (m) und dem ersten Parametersatz (PS1), und mit einem zweiten Ausgangsteil (OP2) mit dem Restsignalteil (s) und dem zweiten Parametersatz (PS2).

2. Audio-Kodierer nach Anspruch 1, wobei der dritte räumliche Parameter (SP3) eine Differenz zwischen dem zweiten räumlichen Parameter (SP2) und dem ersten räumlichen Parameter (SP1) enthält.

3. Audio-Kodierer nach Anspruch 1, wobei der zweite räumliche Parameter (SP2) einen auf Kohärenz basierten Parameter enthält.

4. Audio-Kodierer nach Anspruch 1, wobei der dritte räumliche Parameter (SP3) eine Differenz zwischen einem auf Kohärenz basierten Parameter und einem auf Korrelation basierten Parameter enthält.

5. Audio-Kodierer nach Anspruch 1, wobei der Restsignalteil (s) eine Differenz zwischen dem ersten und dem zweiten Audiosignal (x1, x2) enthält.

6. Audio-Kodierer nach Anspruch 1, wobei das Kodiererkombinationsmodul (ECM) dazu vorgesehen ist, den dominanten und den Restsignalteil (m, s) derart zu erzeugen, dass diese Signalteile (m, s) weniger korreliert sind als das erste und das zweite Audiosignal (x1, x2).

7. Audio-Kodierer nach Anspruch 1, der weiterhin dazu vorgesehen ist, ein drittes, viertes, fünftes und sechstes Audiosignal zu empfangen und diese Signale zusammen mit dem ersten und zweiten Audiosignal (x1, x2) herunter zu mischen und in Reaktion darauf den ersten und zweiten Ausgangsteil zu erzeugen.

8. Audio-Decoder zum Erzeugen eines Mehrkanal-Audiosignals auf Basis eines codierten Signals, wobei der Decoder Folgendes umfasst:

- eine Decoderkombinationseinheit (DU) zum Erzeugen eines ersten und zweiten Audiosignals auf Basis eines dominanten Signalteils, eines Restsignalteils und eines ersten und zweiten Satzes von Parametern, wobei der erste und zweite Parametersatz eine Beschreibung räumlicher Eigenschaften des ersten und zweiten Audiosignals enthalten, wobei der Restsignalteil und der zweite Parametersatz dazu vorgesehen sind, eine Mischmatrix (MM) zu bestimmen, die zum Erzeugen des ersten und zweiten Audiosignals verwendet wird.

9. Audio-Decoder nach Anspruch 8, wobei der Decoder einen Dekorrelator (Dec) enthält, und zwar zum Empfangen des dominanten Signalteils und in Reaktion darauf zum Erzeugen eines dekorrelierten dominanten Signalteils.

10. Audio-Decoder nach Anspruch 9, wobei eine Addierung des Restsignalteils und des dekorrelierten dominanten Signalteils durchgeführt wird, und zwar bei der Bestimmung der Mischmatrix (MM).

11. Audio-Decoder nach Anspruch 10, wobei der Decoder einen Dämpfer (Att) zum Dämpfen des dekorrelierten dominanten Signalteils vor der Addierung desselben zu dem Restsignalteil.

12. Audio-Decoder nach Anspruch 8, vorgesehen zum Empfangen einer Anzahl erster und zweiter Parametersätze und einer Anzahl Restsignalteile zum in Reaktion darauf Erzeugen einer Anzahl erster und zweiter Audiosignale.

13. Audio-Decoder nach Anspruch 12, wobei der Decoder dazu vorgesehen ist, drei Sätze erster und zweiter Parametersätze und drei Restsignalteile zu empfangen, damit in Reaktion darauf drei Sätze erster und zweiter Audiosignale erzeugt werden.

**14.** Verfahren zum Codieren eines Mehrkanal-Audiosignals, wobei dieses verfahren die nachfolgenden Verfahrensschritte umfasst:

1) das Erzeugen eines dominanten Signalteils (m) und eines Restsignalteils (s), wobei es sich um eine kombinierte Darstellung eines ersten und eines zweiten Audiosignals (x1, x2) handelt, wobei der dominante und der Restsignalteil (m, s) durch Anwendung einer mathematischen Prozedur an dem ersten und zweiten Audiosignal (x1, x2) erhalten werden, wobei die mathematische Prozedur erfordert, dass ein erster räumlicher Parameter (SP1) eine Beschreibung räumlicher Eigenschaften des ersten und des zweiten Audiosignals (x1, x2) enthält,
2) das Erzeugen eines ersten Parametersatzes, der einen zweiten räumlichen Parameter enthält,
3) das Erzeugen eines zweiten Parametersatzes, der einen dritten räumlichen Parameter enthält, **gekennzeichnet durch**
4) Erzeugung eines kodierten Ausgangssignals mit einem ersten Ausgangsteil mit dem dominanten Signalteil (m) und dem ersten Parametersatz, und mit einem zweiten Ausgangsteil mit dem Restsignalteil (s) und dem zweiten Parametersatz.

**15.** Verfahren zum Erzeugen eines Mehrkanal-Audiosignals auf Basis eines codierten Signals, wobei das Verfahren die nachfolgenden Verfahrensschritte umfasst:

1) das Empfangen des codierten Signals mit einem dominanten Signalteil, einem Restsignalteil und einem ersten und zweiten Parametersatz mit einer Beschreibung räumlicher Eigenschaften erster und zweiter Audiosignale,
2) das Bestimmen einer Mischmatrix (MM) auf Basis des Restsignalsteils und des zweiten Parametersatzes,
3) das Erzeugen des ersten und zweiten Audiosignals auf Basis der bestimmten Mischmatrix.

**16.** Verfahren nach Anspruch 15, wobei das Verfahren den nachfolgenden Verfahrensschritt umfasst: die Dekorrelation des dominanten Signalteils und in Reaktion darauf die Erzeugung eines dekorrelierten dominanten Signalteils.

**17.** Verfahren nach Anspruch 16, wobei das Verfahren weiterhin den nachfolgenden Verfahrensschritt umfasst: das Addieren des Restsignalteils und des dekorrelierten dominanten Signalteils.

**18.** Verfahren nach Anspruch 17, wobei das Bestimmen der Mischmatrix (MM) auf dem addierten Signalteil und dem dekorrelierten dominanten Signalteil basiert.

**19.** Verfahren nach Anspruch 15, wobei das Verfahren Folgendes umfasst: das Empfangen einer Anzahl Sätze erster und zweiter Parametersätze und einer Anzahl Restsignalteile, und zwar zum in Reaktion darauf Erzeugen einer Anzahl Sätze erster und zweiter Audiosignale.

**20.** Verfahren nach Anspruch 19, wobei das Verfahren Folgendes umfasst: das Empfangen dreier Sätze erster und zweiter Parametersätze und dreier Restsignalteile zum in Reaktion darauf Erzeugen dreier Sätze erster und zweiter Audiosignale.

**21.** Codiertes Mehrkanal-Audiosignal, das Folgendes umfasst:

- einen ersten Signalteil (OP1) mit einem dominanten Signalteil (m) und einem ersten Parametersatz (PS1) mit einer Beschreibung räumlicher Eigenschaften des ersten und des zweiten Audiosignals (x1, x2), und
- einen zweiten Signalteil (OP2) mit einem Restsignalteil (s) und einem zweiten Parametersatz (PS2) mit einer Beschreibung räumlicher Eigenschaften des ersten und zweiten Audiosignals (x1, x2).

**22.** Speichermedium, auf dem ein Signal wie in Anspruch 21 gespeichert ist.

**23.** Mit einem Computer durchführbarer Programmcode, vorgesehen zum Durchführen des Verfahrens nach Anspruch 14, wenn dies in einem Computer durchgeführt wird.

**24.** Mit einem Computer auslesbares Speichermedium mit einem vom Computer durchführbaren Programmcode nach Anspruch 23.

**25.** Mit einem Computer durchführbarer Programmcode, vorgesehen zum Durchführen des Verfahrens nach Anspruch 15, wenn in einem Computer durchgeführt.

**26.** Mit einem Computer auslesbares Speichermedium mit einem vom Computer durchführbaren Programmcode nach Anspruch 25.

**27.** Anordnung mit einem Kodierer nach Anspruch 1.

**28.** Anordnung mit einem Decoder nach Anspruch 8.


**Revendications**

**1.** Codeur audio qui est adapté de manière à coder un signal audio multivoie, le codeur comprenant :

- un module de combinaison de codeur (ECM) pour générer une partie de signal dominante (m) et une partie de signal résiduelle (s) étant une représentation combinée de premier et deuxième signaux audio (x1, x2), les parties de signal dominante et résiduelle (m, s) étant obtenues par l'application d'une procédure mathématique aux premier et deuxième signaux audio (x1, x2), dans lequel la procédure mathématique implique un premier paramètre spatial (SP1) comprenant une description de propriétés spatiales des premier et deuxième signaux audio (x1, x2),
- un générateur de paramètres (PG) pour générer :

un premier ensemble de paramètres (PS1) comprenant un deuxième paramètre spatial (SP2), et
un deuxième ensemble de paramètres (PS2) comprenant un troisième paramètre spatial (SP3), et

- **caractérisé par** le codeur comprenant un générateur de sortie pour générer un signal de sortie codé comprenant :

une première partie de sortie (OP1) comprenant la partie de signal dominante (m) et le premier ensemble de paramètres (PS1), et
une deuxième partie de sortie (OP2) comprenant la partie de signal résiduelle (s) et le deuxième ensemble de paramètres (PS2).

**2.** Codeur audio selon la revendication 1, dans lequel le troisième paramètre spatial (SP3) comprend une différence entre le deuxième paramètre spatial (SP2) et le premier paramètre spatial (SP1).

**3.** Codeur audio selon la revendication 1, dans lequel le deuxième paramètre spatial (SP2) comprend un paramètre qui est basé sur la cohérence.

**4.** Codeur audio selon la revendication 1, dans lequel le troisième paramètre spatial (SP3) comprend une différence entre un paramètre qui est basé sur la cohérence et un paramètre qui est basé sur la corrélation.

**5.** Codeur audio selon la revendication 1, dans lequel la partie de signal résiduelle (s) comprend une différence entre les premier et deuxième signaux audio (x1, x2).

**6.** Codeur audio selon la revendication 1, dans lequel le module de combinaison de codeur (ECM) est adapté de manière à générer les parties de signal dominante et résiduelle (m, s) de telle façon que ces parties de signal (m, s) soient moins corrélées que les premier et deuxième signaux audio (x1, x2).

**7.** Codeur audio selon la revendication 1, qui est en outre adapté de manière à recevoir des troisième, quatrième, cinquième et sixième signaux audio et de manière à sous-mixer ces signaux en même temps que les premier et deuxième signaux audio (x1, x2) et de manière à générer les première et deuxième parties de sortie en réaction à cela.

**8.** Décodeur audio pour générer un signal audio multivoie qui est basé sur un signal codé, le décodeur comprenant :

- une unité de combinaison de décodeur (DU) pour générer des premier et deuxième signaux audio qui sont basés sur une partie de signal dominante, une partie de signal résiduelle et des premier et deuxième ensembles de paramètres, les premier et deuxième ensembles de paramètres comprenant une description de propriétés spatiales des premier et deuxième signaux audio, dans lequel la partie de signal résiduelle et le deuxième ensemble de paramètres sont impliqués dans la détermination d'une matrice de mixage (MM) qui est utilisée pour générer les premier et deuxième signaux audio.

**9.** Décodeur audio selon la revendication 8, dans lequel le décodeur comprend un décorrélateur (Dec) pour recevoir la partie de signal dominante et pour générer une partie de signal dominante décorrélée en réaction à cela.

**10.** Décodeur audio selon la revendication 9, dans lequel une addition de la partie de signal résiduelle et de la partie de signal dominante décorrélée est impliquée dans la détermination de la matrice de mixage (MM).

**11.** Décodeur audio selon la revendication 10, dans lequel le décodeur comprend un atténuateur (Att) pour atténuer la partie de signal dominante décorrélée avant son addition à la partie de signal résiduelle.

**12.** Décodeur audio selon la revendication 8, qui est adapté de manière à recevoir une pluralité d'ensembles de premier et deuxième ensembles de paramètres et une pluralité de parties de signal résiduelles de manière à générer une pluralité d'ensembles de premier et deuxième signaux audio en réaction à cela.

**13.** Décodeur audio selon la revendication 12, dans lequel le décodeur est adapté de manière à recevoir trois ensembles de premier et deuxième ensembles de paramètres et trois parties de signal résiduelles de manière à générer trois ensembles de premier et deuxième signaux audio en réaction à cela.

**14.** Procédé de codage d'un signal audio multivoie comprenant les étapes suivantes consistant à :

1) générer une partie de signal dominante (m) et une partie de signal résiduelle (s) étant une représentation combinée de premier et deuxième signaux audio (x1, x2), les parties de signal dominante et résiduelle (m, s) étant obtenues par l'application d'une procédure mathématique aux premier et deuxième signaux audio (x1, x2), dans lequel la procédure mathématique implique un premier paramètre spatial (SP1) comprenant une description de propriétés spatiales des premier et deuxième signaux audio (x1, x2),
2) générer un premier ensemble de paramètres comprenant un deuxième paramètre spatial,
3) générer un deuxième ensemble de paramètres comprenant un troisième paramètre spatial, et
4) **caractérisé par** l'étape suivante consistant à générer un signal de sortie codé comprenant une première partie de sortie comprenant la partie de signal dominante (m) et le premier ensemble de paramètres, et une deuxième partie de sortie comprenant la partie de signal résiduelle (s) et le deuxième ensemble de paramètres.

**15.** Procédé de génération d'un signal audio multivoie qui est basé sur un signal codé, le procédé comprenant les étapes suivantes consistant à :

1) recevoir le signal codé comprenant une partie de signal dominante, une partie de signal résiduelle, et des premier et deuxième ensembles de paramètres comprenant une description de propriétés spatiales de premier et deuxième signaux audio,
2) déterminer une matrice de mixage (MM) qui est basée sur la partie de signal résiduelle et le deuxième ensemble de paramètres, et
3) générer les premier et deuxième signaux audio qui sont basés sur la matrice de mixage déterminée.

**16.** Procédé selon la revendication 15, comprenant les étapes suivantes consistant à décorréler la partie de signal dominante et à générer la partie de signal dominante décorrélée en réaction à cela.

**17.** Procédé selon la revendication 16, comprenant en outre l'étape suivante consistant à additionner la partie de signal résiduelle et la partie de signal dominante décorrélée.

**18.** Procédé selon la revendication 17, dans lequel la détermination de la matrice de mixage (MM) est basée sur la partie de signal résiduelle ajoutée et la partie de signal dominante décorrélée.

**19.** Procédé selon la revendication 15, comprenant la réception d'une pluralité d'ensembles de premier et deuxième ensembles de paramètres et d'une pluralité de parties de signal résiduelles de manière à générer une pluralité d'ensembles de premier et deuxième signaux audio en réaction à cela.

**20.** Procédé selon la revendication 19, comprenant la réception de trois ensembles de premier et deuxième ensembles de paramètres et de trois parties de signal résiduelles de manière à générer trois ensembles de premier et deuxième signaux audio en réaction à cela.

**21.** Signal audio multivoie codé comprenant :

- une première partie de signal (OP1) comprenant une partie de signal dominante (m) et un premier ensemble de paramètres (PS2) comprenant une description de propriétés spatiales de premier et deuxième signaux audio (x1, x2), et
- une deuxième partie de signal (OP2) comprenant une partie de signal résiduelle (s) et un deuxième ensemble de paramètres (PS2) comprenant une description de propriétés spatiales des premier et deuxième signaux audio (x1, x2).

**22.** Support de stockage ayant stocké sur lui un signal selon la revendication 21.

**23.** Code de programme exécutable par ordinateur qui est adapté de manière à mettre en oeuvre le procédé selon la revendication 14 lorsqu'il est exécuté sur un ordinateur.

**24.** Support de stockage lisible par ordinateur comprenant un code de programme exécutable par ordinateur selon la revendication 23.

**25.** Code de programme exécutable par ordinateur qui est adapté de manière à mettre en oeuvre le procédé selon la revendication 15 lorsqu'il est exécuté sur un ordinateur.

**26.** Support de stockage lisible par ordinateur comprenant un code de programme exécutable par ordinateur selon la revendication 25.

**27.** Dispositif comprenant un codeur selon la revendication 1.

**28.** Dispositif comprenant un décodeur selon la revendication 8.

FIG.1

FIG.2

FIG.3

FIG.4

FIG.5

EP 1 866 911 B1

FIG.6

EP 1 866 911 B1

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0918407 A2

### Non-patent literature cited in the description

- **Christof Faller.** Coding of Spatial Audio Compatible with Different Playback Formats. *AES Convention Paper, AES 117th Convention,* 28 October 2004